# DEMANDE DE BREVET EUROPEEN

(11) **EP 3 719 839 A1**
(43) Date de publication de la demande: **07.10.2020**
(21) Numéro de dépôt: 20167692.1
(22) Date de dépôt: 02.04.2020
(51) Int. Cl.: H01L 27/02, H01L 29/87, H02H 9/04

(54) **DISPOSITIF DE PROTECTION CONTRE DES DÉCHARGES ÉLECTROSTATIQUES**

(30) Priorité: 05.04.2019 FR 1903658
(71) Demandeur: STMicroelectronics (Tours) SAS, 37100 Tours (FR)
(72) Inventeur: LACONDE, Eric, 37100 TOURS (FR); ORY, Olivier, 37100 TOURS (FR)
(74) Mandataire: Cabinet Beaumont

(57) **Abrégé**

La présente description concerne un dispositif (200) de protection contre des décharges électrostatiques, comportant :
- un substrat semiconducteur (101) d'un premier type de conductivité revêtu d'une couche semiconductrice (103) du second type de conductivité ;
- à l'interface entre le substrat (101) et la couche (103), une région enterrée (105) du second type de conductivité ;
- des premier (107) et deuxième (109) caissons du premier type de conductivité formés dans la couche (103) du côté de sa face opposée au substrat (101) ;
- une région (111) du deuxième type de conductivité formée dans le deuxième caisson (109) du côté de sa face opposée au substrat (101) ; et
- une première région d'arrêt de canal (201) du deuxième type de conductivité formée dans la couche (103) du côté de sa face opposée au substrat (101) et séparant latéralement les premier (107) et deuxième (109) caissons.

## Description

### Domaine technique

La présente description concerne de façon générale les circuits électroniques, et vise plus particulièrement un dispositif de protection d'un circuit électronique contre des décharges électrostatiques.

### Technique antérieure

On a déjà proposé des dispositifs de protection de circuits électroniques contre des décharges électrostatiques, comportant des thyristors latéraux pour évacuer les surtensions liées aux décharges électrostatiques.

Les structures connues de dispositifs de protection contre des décharges électrostatiques à base de thyristors latéraux présentent toutefois divers inconvénients.

Il serait souhaitable de pallier au moins en partie certains de ces inconvénients.

### Résumé de l'invention

Pour cela, un mode de réalisation prévoit un dispositif de protection contre des décharges électrostatiques, comportant :
- un substrat semiconducteur d'un premier type de conductivité revêtu d'une couche semiconductrice du second type de conductivité ;
- à l'interface entre le substrat et la couche semiconductrice, une région enterrée du second type de conductivité de niveau de dopage supérieur à celui de la couche semiconductrice ;
- des premier et deuxième caissons du premier type de conductivité formés dans la couche semiconductrice du côté de sa face opposée au substrat ;
- une région du deuxième type de conductivité formée dans le deuxième caisson du côté de sa face opposée au substrat ; et
- une première région d'arrêt de canal du deuxième type de conductivité de niveau de dopage supérieur à celui de la couche semiconductrice, disjointe des premier et deuxième caissons, formée dans la couche semiconductrice du côté de sa face opposée au substrat et séparant latéralement les premier et deuxième caissons,
   dans lequel le premier caisson est connecté à une première borne de connexion du dispositif et le deuxième caisson et la région du deuxième type de conductivité formée dans le deuxième caisson sont connectés à une deuxième borne de connexion du dispositif.

Selon un mode de réalisation, en vue de dessus, la première région d'arrêt de canal entoure entièrement chacun des premier et deuxième caissons.

Selon un mode de réalisation, le dispositif comporte un premier mur d'isolation vertical entourant, en vue de dessus, la première région d'arrêt de canal et les premier et deuxième caissons, le premier mur d'isolation s'étendant à travers toute l'épaisseur de la couche semiconductrice et de la région enterrée.

Selon un mode de réalisation, le dispositif comporte en outre, dans une partie du dispositif ne comportant pas la région enterrée, un deuxième mur d'isolation vertical délimitant latéralement une première diode définie par la jonction entre le substrat et la couche semiconductrice.

Selon un mode de réalisation, la portion de la couche semiconductrice délimitée latéralement par le deuxième mur d'isolation vertical est connectée à la deuxième borne de connexion du dispositif par l'intermédiaire d'une zone de reprise de contact.

Selon un mode de réalisation, la portion de la couche semiconductrice délimitée latéralement par le deuxième mur d'isolation vertical est connectée à la première borne de connexion du dispositif par l'intermédiaire d'une zone de reprise de contact, et le substrat est connecté à la deuxième borne de connexion du dispositif.

Selon un mode de réalisation, le dispositif comporte en outre :
- des troisième et quatrième caissons du premier type de conductivité formés dans la couche semiconductrice du côté de sa face opposée au substrat ;
- une région du deuxième type de conductivité formée dans le quatrième caisson du côté de sa face opposée au substrat ; et
- une deuxième région d'arrêt de canal du deuxième type de conductivité de niveau de dopage supérieur à celui de la couche semiconductrice, formée dans la couche semiconductrice du côté de sa face opposée au substrat et séparant latéralement les troisième et quatrième caissons,
   le troisième caisson étant connecté à la deuxième borne de connexion du dispositif et le quatrième caisson et la région du deuxième type de conductivité formée dans le quatrième caisson étant connectés à la première borne de connexion du dispositif.

Selon un mode de réalisation, en vue de dessus, la deuxième région d'arrêt de canal entoure entièrement chacun des troisième et quatrième caissons.

Selon un mode de réalisation, le dispositif comporte en outre un troisième mur d'isolation vertical entourant, en vue de dessus, la deuxième région d'arrêt de canal et les troisième et quatrième caissons, le troisième mur d'isolation s'étendant à travers toute l'épaisseur de la couche semiconductrice et de la région enterrée.

Selon un mode de réalisation, le dispositif comporte en outre une région du deuxième type de conductivité formée dans le premier caisson du côté de sa face opposée au substrat, la région du deuxième type de conductivité formée dans le premier caisson étant connectée à la première borne de connexion du dispositif.

Selon un mode de réalisation, le dispositif comporte en outre, dans une partie du dispositif ne comportant pas la région enterrée, un quatrième mur d'isolation vertical délimitant latéralement une deuxième diode définie par la jonction entre le substrat et la couche semiconductrice.

Selon un mode de réalisation, la portion de la couche semiconductrice délimitée latéralement par le quatrième mur d'isolation vertical est connectée à la première borne de connexion du dispositif par l'intermédiaire d'une zone de reprise de contact.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe schématique d'un exemple d'un dispositif de protection contre des décharges électrostatiques ;
la figure 2 est une vue en coupe schématique d'un exemple d'un dispositif de protection contre des décharges électrostatiques selon un premier mode de réalisation ;
la figure 3 est une vue en coupe schématique d'un exemple d'un dispositif de protection contre des décharges électrostatiques selon un deuxième mode de réalisation ;
la figure 4 est une vue de dessus schématique d'une variante de réalisation du dispositif de la figure 3 ;
la figure 5 est une vue de dessus schématique d'une autre variante de réalisation du dispositif de la figure 3 ;
la figure 6 est une vue en coupe schématique d'un exemple d'un dispositif de protection contre des décharges électrostatiques selon un troisième mode de réalisation ; et
la figure 7 est une vue en coupe schématique d'un exemple d'un dispositif de protection contre des décharges électrostatiques selon un quatrième mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les circuits électroniques susceptibles d'être protégés par les dispositifs de protection décrits n'ont pas été détaillés, les modes de réalisation décrits étant compatibles avec les circuits électroniques usuels nécessitant une protection contre des décharges électrostatiques.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

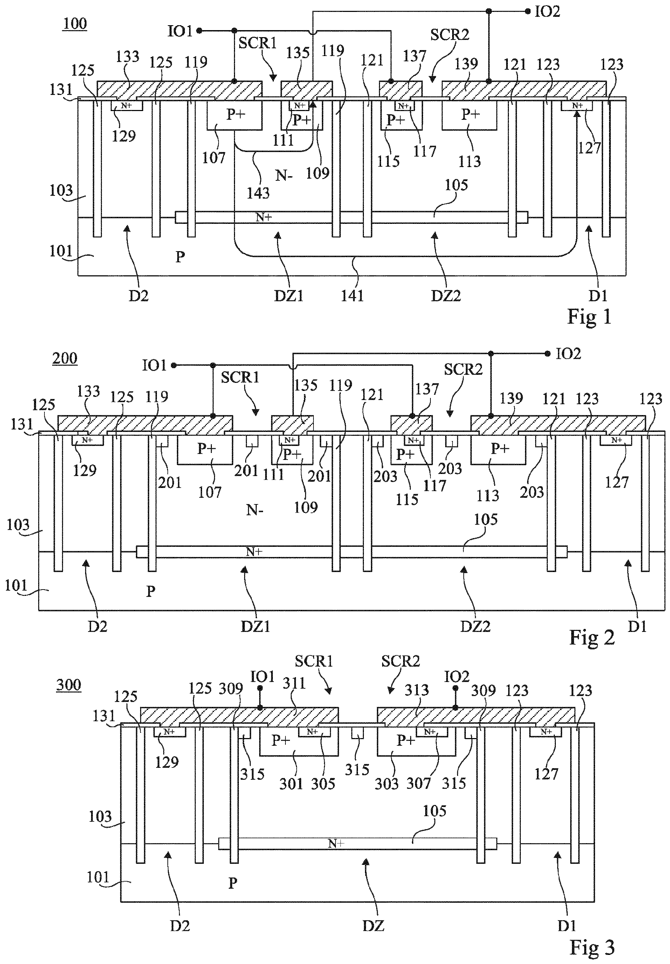

La figure 1 est une vue en coupe schématique d'un exemple d'un dispositif 100 de protection d'un circuit électronique (non représenté) contre des décharges électrostatiques.

Le dispositif 100 est par exemple un composant monolithique discret distinct du circuit à protéger, comportant au moins deux bornes de connexion destinées à être connectées respectivement à deux bornes de connexion distinctes du circuit à protéger.

Dans l'exemple de la figure 1, le dispositif 100 comporte deux bornes de connexion 101 et 102 destinées à être connectées respectivement à deux bornes de connexion distinctes du circuit à protéger. Le dispositif 100 de la figure 1 est un dispositif de protection bidirectionnel, c'est-à-dire qu'il est adapté à évacuer les surtensions positives et négatives susceptibles de survenir entre ses bornes 101 et 102, et qu'il est destiné, en fonctionnement normal (en l'absence de surtension), à recevoir des tensions positives et négatives entre ses bornes 101 et 102.

Le dispositif 100 comprend un substrat semiconducteur 101 dopé de type P, par exemple un substrat en silicium.

Le dispositif 100 comprend en outre une couche 103 faiblement dopée de type N, par exemple une couche épitaxiée, revêtant la face supérieure du substrat 101. La couche 103 s'étend par exemple sur toute la surface supérieure du substrat 101.

Le dispositif 100 comprend en outre une région enterrée 105 fortement dopée de type N disposée à l'interface entre le substrat 101 et la couche 103. Dans cet exemple, la région 105 s'étend dans une partie supérieure du substrat 101 et dans une partie inférieure de la couche 103. La région 105 est par exemple formée par implantation d'éléments dopants de type N du côté de la face supérieure du substrat 101, avant l'étape de croissance épitaxiale de la couche 103. Dans l'exemple représenté, la région 105 est localisée latéralement, c'est-à-dire qu'elle ne s'étend pas sur toute la surface du substrat 101. Dans l'exemple représenté, la région 105 est localisée dans une partie centrale du dispositif.

Le dispositif 100 comprend en outre un premier thyristor latéral SCR1 comprenant deux caissons localisés de type P 107 et 109 formés dans une partie supérieure de la couche 103 et une région localisée de type N 111 formée dans une partie supérieure du caisson 109. Dans cet exemple, les caissons 107 et 109 sont disjoints. Chaque caisson s'étend verticalement depuis la face supérieure de la couche 103 sur une épaisseur inférieure à l'épaisseur de la couche 103. Les caissons 107 et 109 ont par exemple sensiblement la même profondeur et le même niveau de dopage. Dans cet exemple, les caissons 107 et 109 sont disposés en vis-à-vis (à l'aplomb) de la région enterrée 105. La région 111 s'étend latéralement sur une partie seulement de la surface du caisson 109, et s'étend verticalement depuis la face supérieure du caisson 109, sur une épaisseur inférieure à l'épaisseur du caisson 109. Le thyristor latéral SCR1 est un thyristor de type PNPN formé par le caisson de type P 107, la couche 103, le caisson de type P 109, et la région de type N 111. La région d'anode du thyristor SCR1 correspond au caisson de type P 107 et la région de cathode du thyristor SCR1 correspond à la région de type N 111.

Le dispositif 100 comprend de plus un deuxième thyristor latéral SCR2 comprenant deux caissons localisés de type P 113 et 115 formés dans une partie supérieure de la couche 103, et une région localisée de type N 117 formée dans une partie supérieure du caisson 115. Dans cet exemple, les caissons 113 et 115 sont disjoints et distincts des caissons 107 et 109. Chacun des caissons 113 et 115 s'étend verticalement depuis la face supérieure de la couche 103 sur une épaisseur inférieure à l'épaisseur de la couche 103. Les caissons 113 et 115 ont par exemple sensiblement la même profondeur et le même niveau de dopage que les caissons 107 et 109. Dans cet exemple, les caissons 113 et 115 sont disposés en vis-à-vis (à l'aplomb) de la région enterrée 105. La région 117 s'étend latéralement sur une partie seulement de la surface du caisson 115, et s'étend verticalement depuis la face supérieure du caisson 115, sur une épaisseur inférieure à l'épaisseur du caisson 115. La région 117 a par exemple sensiblement la même profondeur et le même niveau de dopage que la région 111. Le thyristor latéral SCR2 est un thyristor de type PNPN formé par le caisson de type P 113, la couche 103, le caisson de type P 115, et la région de type N 117. La région d'anode du thyristor SCR2 correspond au caisson de type P 113 et la région de cathode du thyristor SCR2 correspond à la région de type N 117.

Dans cet exemple, le thyristor SCR1 est entièrement entouré latéralement par un premier mur d'isolation vertical 119, et le thyristor SCR2 est entièrement entouré latéralement par un deuxième mur d'isolation vertical 121. Chacun des murs d'isolation 119 et 121 sépare latéralement le thyristor SCR1 du thyristor SCR2. Les murs d'isolation 119 et 121 sont par exemple en oxyde de silicium. Dans cet exemple, chacun des murs d'isolation 119 et 121 s'étend verticalement depuis la face supérieure de la couche 103, traverse toute l'épaisseur de la couche 103 et de la région 105, et s'interrompt dans le substrat 101. Dans cet exemple, la région enterrée 105 s'étend latéralement sur toute la surface inférieure de la portion de la couche 103 délimitée par le mur d'isolation 119, et sur toute la surface inférieure de la portion de la couche 103 délimitée par le mur d'isolation 121.

La portion de la région enterrée 105 délimitée latéralement par le mur d'isolation 119 forme avec le substrat 101 une jonction PN définissant une première diode Zener DZ1. La région d'anode de la diode Zener DZ1 est formée par le substrat 101 et la région de cathode de la diode Zener DZ1 est formée par la portion de la région 105 délimitée latéralement par le mur d'isolation 119. De façon similaire, la portion de la région enterrée 105 délimitée latéralement par le mur d'isolation 121 forme avec le substrat 101 une jonction PN définissant une deuxième diode Zener DZ2. La région d'anode de la diode Zener DZ2 est formée par le substrat 101 et la région de cathode de la diode Zener DZ2 est formée par la portion de la région 105 entourée latéralement par le mur d'isolation 121.

Le dispositif 100 comprend de plus, dans une région périphérique dans laquelle la région enterrée 105 n'est pas présente, une première diode D1 définie par la jonction PN entre le substrat 101 et la couche 103. La diode D1 est entourée latéralement par un mur d'isolation vertical 123, par exemple de même nature que les murs d'isolation 119 et 121. Le mur 123 sépare latéralement la diode D1 des thyristors SCR1 et SCR2. Dans cet exemple, le mur d'isolation 123 s'étend verticalement depuis la face supérieure de la couche 103, traverse toute l'épaisseur de la couche 103, et s'interrompt dans le substrat 101. La région d'anode de la diode D1 est formée par le substrat 101 et la région de cathode de la diode D1 est formée par la portion de la couche 103 entourée latéralement par le mur d'isolation 123.

Le dispositif 100 comprend de plus, dans une région périphérique dans laquelle la région enterrée 105 n'est pas présente, une deuxième diode D2 définie par la jonction PN entre le substrat 101 et la couche 103. La diode D2 est entourée latéralement par un mur d'isolation vertical 125, par exemple de même nature que les murs d'isolation 119, 121 et 123. Le mur 125 sépare latéralement la diode D2 des thyristors SCR1 et SCR2 et de la diode D1. Dans cet exemple, le mur d'isolation 125 s'étend verticalement depuis la face supérieure de la couche 103, traverse toute l'épaisseur de la couche 103, et s'interrompt dans le substrat 101. La région d'anode de la diode D2 est formée par le substrat 101 et la région de cathode de la diode D2 est formée par la portion de la couche 103 entourée latéralement par le mur d'isolation 125.

Dans l'exemple représenté, le dispositif 100 comprend en outre, dans une partie supérieure de la région de cathode de la diode D1, une zone de reprise de contact 127 fortement dopée de type N, et, dans une partie supérieure de la région de cathode de la diode D2, une zone de reprise de contact 129 fortement dopée de type N. Chacune des zones 127 et 129 s'étend verticalement depuis la face supérieure de la couche 103 sur une épaisseur inférieure à l'épaisseur de la couche 103. Les zones 127 et 129 ont par exemple sensiblement la même profondeur et le même niveau de dopage.

Le dispositif 100 de la figure 1 comprend de plus une couche isolante de passivation 131, par exemple en oxyde de silicium, revêtant la face supérieure de la couche 103. Dans cet exemple, la couche de passivation 131 est disposée sur et en contact avec la face supérieure de la couche 103 et sur et en contact avec la face supérieure des murs d'isolation 119, 121, 123 et 125. La couche de passivation 131 comprend une pluralité d'ouvertures traversantes localisées permettant la reprise de contacts électriques sur différentes régions semiconductrices du dispositif. Plus particulièrement, la couche 131 comprend une ouverture localisée en vis-à-vis d'une partie de la face supérieure de la zone de reprise de contact 127, une ouverture localisée en vis-à-vis d'une partie de la face supérieure de la zone de reprise de contact 129, une ouverture localisée en vis à vis d'une partie de la face supérieure du caisson 107, une ouverture localisée en vis-à-vis d'une partie de la face supérieure du caisson 113, une ouverture localisée en vis-à-vis d'une partie de la face supérieure de la région 111 et d'une partie non occupée par la région 111 de la face supérieure du caisson 109, et une ouverture localisée en vis à vis d'une partie de la face supérieure de la région 117 et d'une partie non occupée par la région 117 de la face supérieure du caisson 115.

Le dispositif 100 comprend de plus, du côté de la face supérieure de la couche de passivation 131, une première métallisation 133 en contact avec les parties exposées de la face supérieure du caisson de type P 107 et de la zone de type N 129, une deuxième métallisation 135 en contact avec les parties exposées de la face supérieure du caisson de type P 109 et de la région de type N 111, une troisième métallisation 137 en contact avec les parties exposées de la face supérieure du caisson de type P 115 et de la région de type N 117, et une quatrième métallisation 139 en contact avec les parties exposées de la face supérieure du caisson de type P 113 et de la zone de type N 127. Les métallisations 133 et 137 sont connectées à la borne de connexion 101 du dispositif, et les métallisations 135 et 139 sont connectées à la borne de connexion 102 du dispositif.

Le niveau de dopage de type P du substrat 101 est par exemple compris entre 9*10¹⁸ et 5*10¹⁹ atomes/cm³. Le niveau de dopage de type N de la couche 103 est par exemple compris entre 5*10¹³ et 2*10¹⁴ atomes/cm³. Le niveau de dopage de type N de la région enterrée 105 est par exemple compris entre 1*10¹⁸ et 1*10¹⁹ atomes/cm³. Le niveau de dopage de type P des caissons 107, 109, 113 et 115 est par exemple compris entre 1*10¹⁸ et 1*10¹⁹ atomes/cm³. Le niveau de dopage de type N des régions 111 et 117 est par exemple compris entre 5*10¹⁸ et 5*10¹⁹ atomes/cm³. L'épaisseur du substrat 101 est par exemple comprise entre 40 et 300 µm. L'épaisseur de la couche 103 est par exemple comprise entre 5 et 15 µm. L'épaisseur de la région enterrée 105 est par exemple comprise entre 2 et 5 µm. L'épaisseur des caissons 107, 109, 113 et 115 est par exemple comprise entre 1 et 3 µm. L'épaisseur des régions 111, 117, 129 et 127 est par exemple comprise entre 0,5 et 2,5 µm.

Le fonctionnement du dispositif 100 de la figure 1 va maintenant être décrit.

On considère ici le cas d'une décharge électrostatique conduisant à un pic de surtension positive entre les bornes 101 et 102 du dispositif 100, par exemple une décharge électrostatique telle que définie par la norme IEC 61000, partie 4-2 ou partie 4-5, ou par l'un des modèles parmi le modèle HBM (Human Body Model), le modèle MM (Machine Model) et le modèle CDM (Charged Device Model).

Dès que la surtension atteint le seuil d'avalanche de la diode Zener DZ1, par exemple compris entre 5 et 20 volts, par exemple de l'ordre de 7 volts, un courant circule de la borne 101 vers la borne 102 en passant par la métallisation 133, par le caisson de type P 107, par la diode Zener DZ1, par le substrat 101, par la diode D1, par la zone de reprise de contact 127, et par la métallisation 139. Ce chemin de conduction, aussi appelé chemin d'amorçage, est illustré par une flèche 141 sur la figure 1. Ce courant d'amorçage provoque le déclenchement du thyristor SCR1 qui évacue alors l'intégralité du courant lié à la surtension.

En cas de surtension négative entre les bornes 101 et 102 du dispositif 100, le fonctionnement est similaire, à ceci près que le chemin d'amorçage passe par la métallisation 139, par le caisson de type P 113, par la diode Zener DZ2, par le substrat 101, par la diode D2, par la zone de reprise de contact 129, et par la métallisation 133. Le courant d'amorçage provoque le déclenchement du thyristor SCR2 qui évacue alors l'intégralité du courant lié à la surtension.

Une limitation du dispositif 100 de la figure 1 est que, pendant la phase d'amorçage du thyristor SCR1 ou SCR2, un courant parasite circule entre les bornes 101 et 102 sans passer par la diode Zener DZ1 ou DZ2. Ce courant correspond, dans le cas d'une surtension positive, à un courant de fuite du transistor PNP latéral formé par le caisson 107, la couche 103 et le caisson 109, et, dans le cas d'une surtension négative, à un courant de fuite du transistor PNP latéral formé par le caisson 113, la couche 103, et le caisson 115. Ce chemin de conduction parasite est illustré par une flèche 143 sur la figure 1 (dans le cas d'une surtension positive). Ce courant parasite retarde le franchissement du seuil d'avalanche de la diode Zener DZ1 ou DZ2, et donc l'amorçage du thyristor SCR1 ou SCR2. Autrement dit, ce courant parasite provoque une augmentation du temps nécessaire au déclenchement du dispositif de protection en cas de surtension.

La figure 2 est une vue en coupe schématique d'un exemple d'un dispositif 200 de protection contre des décharges électrostatiques selon un premier mode de réalisation.

Le dispositif 200 de la figure 2 comprend des éléments communs avec le dispositif 100 de la figure 1. Ces éléments communs ne seront pas détaillés à nouveau ci-après. Dans la suite de la description, seules les différences par rapport au dispositif 100 de la figure 1 seront mises en exergue.

Le dispositif 200 de la figure 2 diffère du dispositif 100 de la figure 1 principalement en ce qu'il comprend en outre, dans une partie supérieure de la portion de la couche 103 délimitée latéralement par le mur d'isolation 119, une première région d'arrêt de canal 201 fortement dopée de type N, séparant le caisson de type P 107 du thyristor SCR1, du caisson de type P 109 du même thyristor SCR1. La région d'arrêt de canal s'étend verticalement depuis la face supérieure de la couche 103 jusqu'à une profondeur inférieure à l'épaisseur de la couche 103, par exemple jusqu'à une profondeur inférieure à la profondeur des caissons 107 et 109. Le niveau de dopage de la région d'arrêt de canal 201 est par exemple compris entre 5*10¹⁸ et 5*10¹⁹ atomes/cm³. La profondeur de la région d'arrêt de canal 201 est par exemple comprise entre 10 et 80% de la profondeur des caissons de type P 107 et 109. A titre d'exemple, la région d'arrêt de canal 201 a sensiblement la même profondeur et le même niveau de dopage que les régions de type N 111 et 117 et/ou que les régions de type N 127 et 129.

La région d'arrêt de canal 201 est par exemple disjointe des caissons de type P 107 et 109. A titre d'exemple, la région d'arrêt de canal 201 a, en vue de dessus, la forme de deux anneaux accolés entourant entièrement respectivement le caisson 107 et le caisson 109. Ainsi, en vue de dessus, la région d'arrêt de canal 201 non seulement sépare latéralement le caisson 107 du caisson 109, mais sépare en outre latéralement chacun des caissons 107 et 109 du mur d'isolation vertical 119.

La région d'arrêt de canal 201 est par exemple laissée flottante, c'est-à-dire non connectée à une métallisation de connexion du dispositif. Dans l'exemple représenté, la face supérieure de la région d'arrêt de canal 201 est en contact avec la face inférieure de la couche de passivation 131 sur toute la surface supérieure de la région d'arrêt de canal 201.

Le dispositif 200 de la figure 2 comprend de plus, dans une partie supérieure de la portion de la couche 103 délimitée latéralement par le mur d'isolation 121, une deuxième région d'arrêt de canal 203 fortement dopée de type N, séparant le caisson de type P 113 du thyristor SCR2, du caisson de type P 115 du même thyristor SCR2. La région d'arrêt de canal 203 a par exemple sensiblement la même profondeur et le même niveau de dopage que la région d'arrêt de canal 201.

La région d'arrêt de canal 203 est par exemple disjointe des caissons de type P 113 et 115. A titre d'exemple, la région d'arrêt de canal 203 a, en vue de dessus, la forme de deux anneaux accolés entourant entièrement respectivement le caisson 113 et le caisson 115. Ainsi, en vue de dessus, la région d'arrêt de canal 203 non seulement sépare latéralement le caisson 113 du caisson 115, mais sépare en outre latéralement chacun des caissons 113 et 115 du mur d'isolation vertical 121.

La région d'arrêt de canal 203 est par exemple laissée flottante, c'est-à-dire non connectée à une métallisation de connexion du dispositif. Dans l'exemple représenté, la face supérieure de la région d'arrêt de canal 203 est en contact avec la face inférieure de la couche de passivation 131 sur toute la surface supérieure de la région d'arrêt de canal 203.

La région d'arrêt de canal 201 permet, par rapport au dispositif 100 de la figure 1, de diminuer le gain du transistor PNP latéral formé entre le caisson 107, la couche 103 et le caisson 109. En cas de surtension positive entre les bornes 101 et 102 du dispositif, le courant parasite circulant dans ce transistor pendant la phase d'amorçage du dispositif (chemin de conduction parasite 143 de la figure 1) s'en trouve réduit. Le seuil de déclenchement de la diode Zener DZ1 est donc atteint plus rapidement. Ceci permet de réduire le temps de déclenchement de la protection par rapport au dispositif de la figure 1.

De façon similaire, la région d'arrêt de canal 203 permet de diminuer le gain du transistor PNP latéral formé entre le caisson 113, la couche 103 et le caisson 115, et ainsi de diminuer le temps de déclenchement de la protection en cas de surtension négative entre les bornes de connexion 101 et 102 du dispositif.

La figure 3 est une vue en coupe schématique d'un exemple d'un dispositif 300 de protection contre des décharges électrostatiques selon un deuxième mode de réalisation.

Le dispositif 300 de la figure 3 comprend des éléments communs avec le dispositif 200 de la figure 2. Ces éléments communs ne seront pas détaillés à nouveau ci-après. Dans la suite de la description, seules les différences par rapport au dispositif 200 de la figure 2 seront mises en exergue.

Le dispositif 300 de la figure 3 diffère du dispositif 200 de la figure 2 principalement en ce que, dans le dispositif 300, les caissons de type P des thyristors SCR1 et SCR2 sont mis en commun, ce qui permet de se passer de deux des quatre caissons de type P de la structure de la figure 2.

Plus particulièrement, dans le dispositif 300 de la figure 3, les caissons de type P 107, 109, 113 et 115 et les régions de type N 111 et 117 du dispositif de la figure 2 sont remplacés par deux caissons localisés de type P 301 et 303 formés dans une partie supérieure de la couche 103, et deux régions localisées de type N 305 et 307 formées respectivement dans une partie supérieure du caisson 301 et dans une partie supérieure du caisson 303. Les caissons de type P 301 et 303 sont disjoints. Chaque caisson s'étend verticalement depuis la face supérieure de la couche 103 sur une épaisseur inférieure à l'épaisseur de la couche 103. Les caissons 301 et 303 ont par exemple sensiblement la même profondeur et le même niveau de dopage que les caissons 107, 109, 113 et 115 du dispositif 200 de la figure 2. Les caissons 301 et 303 sont disposés en vis-à-vis (à l'aplomb) de la région enterrée 105. La région de type N 305 s'étend latéralement sur une partie seulement de la surface du caisson 301, et s'étend verticalement depuis la face supérieure du caisson 301, sur une épaisseur inférieure à l'épaisseur du caisson 301. De façon similaire, la région de type N 307 s'étend latéralement sur une partie seulement de la surface du caisson 303, et s'étend verticalement depuis la face supérieure du caisson 303, sur une épaisseur inférieure à l'épaisseur du caisson 303. Les régions 305 et 307 ont par exemple sensiblement la même profondeur et le même niveau de dopage que les régions 111 et 117 du dispositif 200 de la figure 2.

Le thyristor latéral SCR1 est un thyristor de type PNPN formé par le caisson de type P 301, la couche 103, le caisson de type P 303, et la région de type N 307. La région d'anode du thyristor SCR1 correspond au caisson de type P 301 et la région de cathode du thyristor SCR1 correspond à la région de type N 307.

Le thyristor latéral SCR2 est un thyristor de type PNPN formé par le caisson de type P 303, la couche 103, le caisson de type P 301, et la région de type N 305. La région d'anode du thyristor SCR2 correspond au caisson de type P 303 et la région de cathode du thyristor SCR2 correspond à la région de type N 305.

Dans cet exemple, les thyristors SCR1 et SCR2 ne sont pas séparés latéralement l'un de l'autre par un mur d'isolation vertical. Autrement dit, aucun mur d'isolation vertical ne s'étend entre les caissons 301 et 303 du dispositif. L'ensemble comprenant les thyristors SCR1 et SCR2 est en revanche entièrement entouré latéralement par un mur d'isolation vertical 309, qui vient en remplacement des murs d'isolation 119 et 121 du dispositif de la figure 2. Le mur d'isolation 309 est par exemple en oxyde de silicium. Dans cet exemple, le mur d'isolation 309 s'étend verticalement depuis la face supérieure de la couche 103, traverse toute l'épaisseur de la couche 103 et de la région 105, et s'interrompt dans le substrat 101. Dans cet exemple, la région 105 s'étend latéralement sous toute la surface de la portion de la couche 103 délimitée latéralement par le mur d'isolation 309.

La portion de la région enterrée 105 délimitée latéralement par le mur d'isolation 309 forme avec le substrat 101 une jonction PN définissant une diode Zener DZ. La région d'anode de la diode Zener DZ est formée par le substrat 101 et la région de cathode de la diode Zener DZ est formée par la portion de la région 105 délimitée latéralement par le mur d'isolation 309.

Comme le dispositif 200 de la figure 2, le dispositif 300 de la figure 3 comprend de plus, dans une région périphérique dans laquelle la région enterrée 105 n'est pas présente, deux diodes D1 et D2 définies par la jonction PN entre le substrat 101 et la couche 103. Comme dans l'exemple de la figure 2, la diode D1 est délimitée latéralement par un mur d'isolation vertical 123 et la diode D2 est délimitée latéralement par un mur d'isolation vertical 125. Le mur 123 sépare latéralement la diode D1 des thyristors SCR1 et SCR2 et de la diode D2, et le mur 125 sépare latéralement la diode D2 des thyristors SCR1 et SCR2 et de la diode D1. Dans l'exemple représenté, le dispositif 300 comprend en outre, comme dans l'exemple de la figure 2, dans une partie supérieure de la région de cathode de la diode D1, une zone de reprise de contact 127 fortement dopée de type N, et, dans une partie supérieure de la région de cathode de la diode D2, une zone de reprise de contact 129 fortement dopée de type N.

Comme dans l'exemple de la figure 2, le dispositif 300 de la figure 3 comprend de plus une couche isolante de passivation 131, par exemple en oxyde de silicium, revêtant la face supérieure de la couche 103. Dans cet exemple, la couche de passivation 131 est disposée sur et en contact avec la face supérieure de la couche 103 et sur et en contact avec la face supérieure des murs d'isolation 309, 123 et 125. La couche de passivation 131 comprend une pluralité d'ouvertures traversantes localisées permettant la reprise de contacts électriques sur différentes régions semiconductrices du dispositif. Plus particulièrement, la couche 131 comprend une ouverture localisée en vis-à-vis d'une partie de la face supérieure de la zone de reprise de contact 127, une ouverture localisée en vis-à-vis d'une partie de la face supérieure de la zone de reprise de contact 129, une ouverture localisée en vis à vis d'une partie de la face supérieure de la région 305 et d'une partie non occupée par la région 305 de la face supérieure du caisson 301, et une ouverture localisée en vis-à-vis d'une partie de la face supérieure de la région 307 et d'une partie non occupée par la région 307 de la face supérieure du caisson 303.

Le dispositif 300 de la figure 3 comprend de plus, du côté de la face supérieure de la couche de passivation 131, une première métallisation 311 en contact avec les parties exposées de la face supérieure du caisson de type P 301, de la région de type N 305, et de la zone de type N 129, et une deuxième métallisation 313 en contact avec les parties exposées de la face supérieure du caisson de type P 303, de la région de type N 307, et de la zone de type N 127. Les métallisations 311 et 313 sont connectées respectivement aux bornes de connexion 101 et 102 du dispositif.

Le dispositif 300 de la figure 3 comprend en outre, dans une partie supérieure de la portion de la couche 103 délimitée latéralement par le mur d'isolation 309, une région d'arrêt de canal 315 fortement dopée de type N, remplaçant les régions d'arrêt de canal 201 et 203 du dispositif 200 de la figure 2. En vue de dessus, la région d'arrêt de canal 315 sépare latéralement le caisson de type P 301 du caisson de type P 303. La région d'arrêt de canal 315 s'étend verticalement depuis la face supérieure de la couche 103 jusqu'à une profondeur inférieure à l'épaisseur de la couche 103, par exemple jusqu'à une profondeur inférieure à la profondeur des caissons 301 et 303. La région d'arrêt de canal 315 a par exemple sensiblement la même profondeur et le même niveau de dopage que les régions d'arrêt de canal 201 et 203 du dispositif 200 de la figure 2.

La région d'arrêt de canal 315 est par exemple disjointe des caissons de type P 301 et 303. A titre d'exemple, la région d'arrêt de canal 315 a, en vue de dessus, la forme de deux anneaux accolés entourant entièrement respectivement le caisson 301 et le caisson 303. Ainsi, en vue de dessus, la région d'arrêt de canal 315 non seulement sépare latéralement le caisson 301 du caisson 303, mais sépare en outre latéralement chacun des caissons 301 et 303 du mur d'isolation vertical 309.

La région d'arrêt de canal 315 est par exemple laissée flottante, c'est-à-dire non connectée à une métallisation de connexion du dispositif. Dans l'exemple représenté, la face supérieure de la région d'arrêt de canal 315 est en contact avec la face inférieure de la couche de passivation 131 sur toute la surface supérieure de la région d'arrêt de canal 315.

Le fonctionnement du dispositif 300 de la figure 3 est similaire à celui du dispositif 200 de la figure 2.

Plus particulièrement, en cas de décharge électrostatique conduisant à un pic de surtension positive entre les bornes 101 et 102 du dispositif 300, dès que la surtension atteint le seuil d'avalanche de la diode Zener DZ, un courant circule de la borne 101 vers la borne 102 en passant par la métallisation 311, par le caisson de type P 301, par la diode Zener DZ, par le substrat 101, par la diode D1, par la zone de reprise de contact 127, et par la métallisation 313. Ce courant d'amorçage provoque le déclenchement du thyristor SCR1 qui évacue alors l'intégralité du courant lié à la surtension. En cas de surtension négative entre les bornes 101 et 102, le fonctionnement est similaire, à ceci près que le chemin d'amorçage passe par la métallisation 313, par le caisson de type P 303, par la diode Zener DZ, par le substrat 101, par la diode D2, par la zone de reprise de contact 129, et par la métallisation 311. Le courant d'amorçage provoque le déclenchement du thyristor SCR2 qui évacue alors l'intégralité du courant lié à la surtension.

De façon similaire à ce qui a été décrit en relation avec la figure 2, la région d'arrêt de canal 315 permet de limiter le gain du transistor PNP latéral formé entre le caisson 301, la couche 103 et le caisson 303, ce qui permet de réduire le temps de déclenchement de la protection en cas de surtension positive ou négative entre les bornes 101 et 102 du dispositif.

Par rapport au dispositif 200 de la figure 2, le dispositif 300 de la figure 3 présente en outre l'avantage d'être plus compact du fait de la suppression de deux caissons de type P et d'un mur d'isolation latéral.

Dans l'exemple représenté sur la figure 3, le dispositif 300 comprend un unique caisson de type P 301 et une unique région de type N 305 connectés à la borne 101, et un unique caisson de type P 303 et une unique région de type N 307 connectés à la borne 102. En vue de dessus, les caissons 301 et 303 et les régions 305 et 307 ont la forme de bandes allongées, par exemple rectangulaires, parallèles entre elles. Le caisson 301 et la région 305 forment ensemble un premier doigt connecté à la borne 101 via la métallisation 311, et le caisson 303 et la région 307 forment ensemble un deuxième doigt connecté à la borne 102 via la métallisation 313.

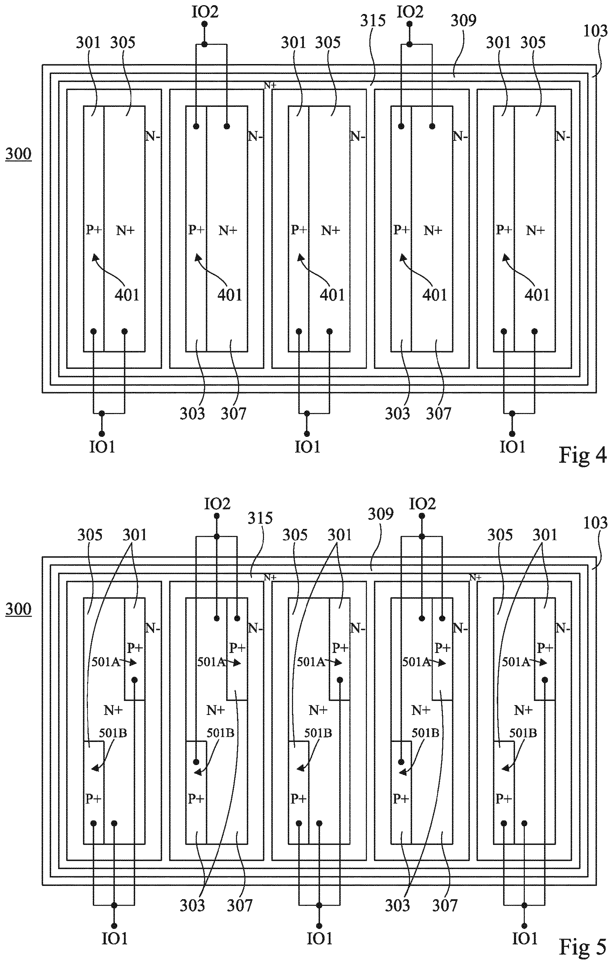

Pour améliorer la robustesse, faciliter l'amorçage et/ou symétriser le comportement de la protection, le dispositif peut comporter plusieurs premiers doigts et/ou plusieurs deuxièmes doigts, interdigités, tel qu'illustré par exemple sur la figure 4.

La figure 4 est une vue de dessus illustrant un exemple de réalisation d'un dispositif interdigité, comportant une alternance de premiers doigts connectés à la borne 101, et de deuxièmes doigts connectés à la borne 102 (trois premiers doigts et deux deuxièmes doigts dans l'exemple représenté). Par souci de simplification, les métallisations 311, 313, les diodes D1, D2, les murs d'isolation 123 et 125, et la couche de passivation 131, n'ont pas été représentés sur la figure 4.

Dans l'exemple de la figure 4, en vue de dessus, la région d'arrêt de canal 315 entoure entièrement l'ensemble des caissons de type P 301 et 303, et sépare latéralement les uns des autres les caissons 301 et 303. Le mur d'isolation périphérique 309 entoure quant à lui entièrement l'ensemble des caissons de type P 301 et 303 et la région d'arrêt de canal 315, mais ne sépare par latéralement les caissons 301 et 303 les uns des autres.

Dans l'exemple de la figure 4, chaque doigt du dispositif de protection comporte une bande de court-circuit d'émetteur 401, constituée par une portion du caisson de type P 301, respectivement 303 du doigt non recouverte par la région de type N 305, respectivement 307, et connectée à la métallisation 311, respectivement 313 (non visibles sur la figure 4) de connexion du doigt à la borne 101, respectivement 102. En vue de dessus, les bandes de court-circuit d'émetteur 401 sont parallèles aux bandes formées par les caissons de type P 301, 303 et par les régions de type N 305, 307. Chaque bande de court-circuit d'émetteur 401 s'étend sur sensiblement toute la longueur du caisson 301, respectivement 303 du doigt, le long d'un grand côté du caisson. Dans le dispositif de la figure 4, les bandes de court-circuit d'émetteur 401 sont toutes situées du même côté des caissons 301 et 303, le côté gauche dans l'orientation de la figure 4.

La figure 5 est une vue de dessus illustrant une variante de réalisation du dispositif de la figure 4. La variante de la figure 5 vise à symétriser encore davantage le comportement de la protection, et à augmenter la surface de semiconducteur effectivement utilisée pour évacuer les surtensions.

Dans le dispositif de la figure 5, chaque doigt du dispositif de protection comporte, en remplacement de la bande de court-circuit d'émetteur 401 de la figure 4, deux bandes de court-circuit d'émetteur disjointes 501A et 501B, s'étendant chacune sur environ la moitié de la longueur du caisson de type P 301, respectivement 303 du doigt. La bande 501A est située le long d'un premier bord du caisson de type P du doigt, le bord droit dans l'orientation de la figure 5, et s'étend dans une première moitié de la longueur du caisson, la moitié supérieure dans l'orientation de la figure 5. La bande 501B est située le long d'un bord opposé du caisson de type P du doigt, le bord gauche dans l'orientation de la figure 5, et s'étend dans la deuxième moitié de la longueur du caisson, la moitié inférieure dans l'orientation de la figure 5.

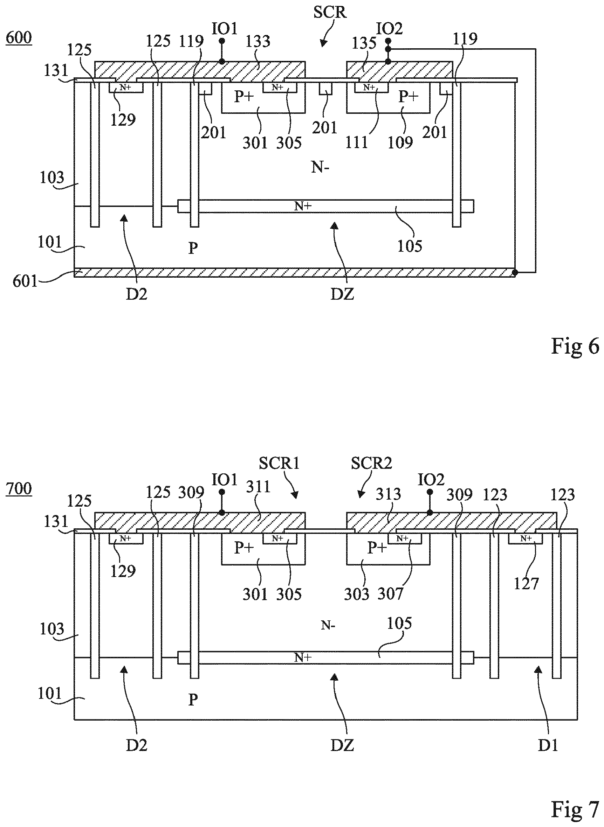

La figure 6 est une vue en coupe schématique d'un exemple d'un dispositif 600 de protection contre des décharges électrostatiques selon un troisième mode de réalisation.

Le dispositif 600 comprend des éléments communs avec le dispositif 200 de la figure 2. Ces éléments communs ne seront pas détaillés à nouveau ci-après. Dans la suite de la description, seules les différences par rapport au dispositif 200 de la figure 2 seront mises en exergue.

Le dispositif 600 de la figure 6 diffère du dispositif 200 de la figure 2 principalement en ce qu'il est unidirectionnel, c'est-à-dire qu'il est adapté à évacuer les surtensions positives et négatives susceptibles de survenir entre ses bornes 101 et 102, mais qu'il est destiné, en fonctionnement normal (en l'absence de surtension), à recevoir uniquement des tensions positives entre ses bornes 101 et 102.

Plus particulièrement, le dispositif 600 de la figure 6 comprend un unique thyristor SCR, correspondant au thyristor SCR1 du dispositif 200 de la figure 2, une unique diode Zener DZ, correspondant à la diode Zener DZ1 du dispositif 200 de la figure 2, et une unique diode D, correspondant à la diode D2 du dispositif 200 de la figure 2. En particulier, le dispositif 600 de la figure 6 ne comprend pas les caissons de type P 113 et 115, les régions de type N 117 et 127, la région d'arrêt de canal 203, les murs d'isolation latéraux 121 et 123, et les métallisations 137 et 139 du dispositif 200 de la figure 2. Le dispositif 600 de la figure 6 comprend en revanche une métallisation de connexion 601 disposée sur et en contact avec la face arrière du substrat 101 et connectée à la même borne de connexion 102 que la métallisation 135.

En cas de décharge électrostatique conduisant à un pic de surtension positive entre les bornes 101 et 102 du dispositif 600, dès que la surtension atteint le seuil d'avalanche de la diode Zener DZ, un courant circule de la borne 101 vers la borne 102 en passant par la métallisation 133, par le caisson de type P 107, par la diode Zener DZ, par le substrat 101, et par la métallisation 601. Ce courant d'amorçage provoque le déclenchement du thyristor SCR qui évacue alors l'intégralité du courant lié à la surtension.

En cas de surtension négative entre les bornes 101 et 102 du dispositif 600, la surtension est directement évacuée par la diode D.

Comme dans l'exemple de la figure 2, la région d'arrêt de canal 201 permet, en cas de surtension positive, de diminuer le gain du transistor PNP latéral formé entre le caisson 107, la couche 103 et le caisson 109, et ainsi de diminuer le temps de déclenchement de la protection.

La figure 7 est une vue en coupe schématique d'un exemple d'un dispositif 700 de protection contre des décharges électrostatiques selon un quatrième mode de réalisation.

Le dispositif 700 de la figure 7 comprend des éléments communs avec le dispositif 300 de la figure 3. Ces éléments communs ne seront pas détaillés à nouveau ci-après. Dans la suite de la description, seules les différences par rapport au dispositif 300 de la figure 3 seront mises en exergue.

Comme dans le dispositif 300 de la figure 3, les thyristors SCR1 et SCR2 du dispositif 700 partagent les deux mêmes caissons de type P 301 et 303. Toutefois, le dispositif 700 de la figure 7 diffère du dispositif 300 de la figure 3 en ce que, dans le dispositif 700 de la figure 7, la région d'arrêt de canal 315 du dispositif 300 de la figure 3 n'est pas présente. Ainsi, dans le dispositif 700, les caissons de type P 301 et 303 sont séparés latéralement uniquement par une portion de la couche 103.

Par rapport au dispositif 300 de la figure 3, le dispositif 700 de la figure 7 ne présente pas l'avantage de déclenchement amélioré procuré par la région d'arrêt de canal 315. Toutefois, par rapport au dispositif 100 de la figure 1, le dispositif 700 de la figure 7 présente l'avantage d'être plus compact du fait de la suppression de deux caissons de type P et d'un mur d'isolation latéral.

Le mode de réalisation de la figure 7 peut être adapté aux variantes des figures 4 et 5. Autrement dit, la région d'arrêt de canal 315 des dispositifs 300 des figures 4 et 5 peut être omise.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux exemples de dimensions et de niveaux de dopage mentionnés dans la présente description.

En outre, dans les exemples de dispositifs de protection décrits ci-dessus, tous les types de conductivité peuvent être inversés.

## Revendications

1. Dispositif (200 ; 300 ; 600) de protection contre des décharges électrostatiques, comportant :
- un substrat semiconducteur (101) d'un premier type de conductivité revêtu d'une couche semiconductrice (103) du second type de conductivité ;
- à l'interface entre le substrat (101) et la couche semiconductrice (103), une région enterrée (105) du second type de conductivité de niveau de dopage supérieur à celui de la couche semiconductrice (103) ;
- des premier (107 ; 301) et deuxième (109 ; 303) caissons du premier type de conductivité formés dans la couche semiconductrice (103) du côté de sa face opposée au substrat (101) ;
- une région (111 ; 307) du deuxième type de conductivité formée dans le deuxième caisson (109 ; 303) du côté de sa face opposée au substrat (101) ; et
- une première région d'arrêt de canal (201 ; 315) du deuxième type de conductivité de niveau de dopage supérieur à celui de la couche semiconductrice (103), disjointe des premier (107 ; 301) et deuxième (109 ; 303) caissons, formée dans la couche semiconductrice (103) du côté de sa face opposée au substrat (101) et séparant latéralement les premier (107 ; 301) et deuxième (109 ; 303) caissons, dans lequel le premier caisson (107 ; 301) est connecté à une première borne de connexion (101) du dispositif et le deuxième caisson (109 ; 303) et la région (111 ; 307) du deuxième type de conductivité formée dans le deuxième caisson sont connectés à une deuxième borne de connexion (102) du dispositif.

2. Dispositif (200 ; 300 ; 600) selon la revendication 1, dans lequel, en vue de dessus, la première région d'arrêt de canal (201 ; 315) entoure entièrement chacun des premier (107 ; 301) et deuxième (109 ; 303) caissons.

3. Dispositif (200 ; 300 ; 600) selon la revendication 1 ou 2, comportant un premier mur d'isolation vertical (119 ; 309) entourant, en vue de dessus, la première région d'arrêt de canal (201 ; 315) et les premier (107 ; 301) et deuxième (109 ; 303) caissons, le premier mur d'isolation (119 ; 309) s'étendant à travers toute l'épaisseur de la couche semiconductrice (103) et de la région enterrée (105).

4. Dispositif (200; 300; 600) selon l'une quelconque des revendications 1 à 3, comportant en outre, dans une partie du dispositif ne comportant pas la région enterrée (105), un deuxième mur d'isolation vertical (123 ; 125) délimitant latéralement une première diode (D1; D) définie par la jonction entre le substrat (101) et la couche semiconductrice (103).

5. Dispositif (200 ; 300) selon la revendication 4, dans lequel la portion de la couche semiconductrice (103) délimitée latéralement par le deuxième mur d'isolation vertical (123) est connectée à la deuxième borne de connexion (102) du dispositif par l'intermédiaire d'une zone de reprise de contact (127).

6. Dispositif (600) selon la revendication 4, dans lequel la portion de la couche semiconductrice (103) délimitée latéralement par le deuxième mur d'isolation vertical (125) est connectée à la première borne de connexion (101) du dispositif par l'intermédiaire d'une zone de reprise de contact (129), et dans lequel le substrat (101) est connecté à la deuxième borne de connexion (102) du dispositif.

7. Dispositif (200) selon l'une quelconque des revendications 1 à 5, comportant en outre :
- des troisième (113) et quatrième (115) caissons du premier type de conductivité formés dans la couche semiconductrice (103) du côté de sa face opposée au substrat (101) ;
- une région (117) du deuxième type de conductivité formée dans le quatrième caisson (115) du côté de sa face opposée au substrat (101) ; et
- une deuxième région d'arrêt de canal (203) du deuxième type de conductivité de niveau de dopage supérieur à celui de la couche semiconductrice (103), formée dans la couche semiconductrice (103) du côté de sa face opposée au substrat (101) et séparant latéralement les troisième (113) et quatrième (115) caissons,
dans lequel le troisième caisson (113) est connecté à la deuxième borne de connexion (102) du dispositif et le quatrième caisson (115) et la région (117) du deuxième type de conductivité formée dans le quatrième caisson sont connectés à la première borne de connexion (101) du dispositif.

8. Dispositif (200) selon la revendication 7, dans lequel, en vue de dessus, la deuxième région d'arrêt de canal (203) entoure entièrement chacun des troisième (113) et quatrième (115) caissons.

9. Dispositif (200) selon la revendication 7 ou 8, comportant en outre un troisième mur d'isolation vertical (121) entourant, en vue de dessus, la deuxième région d'arrêt de canal (203) et les troisième (113) et quatrième (115) caissons, le troisième mur d'isolation (121) s'étendant à travers toute l'épaisseur de la couche semiconductrice (103) et de la région enterrée (105).

10. Dispositif (300) selon l'une quelconque des revendications 1 à 5, comportant en outre une région (305) du deuxième type de conductivité formée dans le premier caisson (301) du côté de sa face opposée au substrat (101), la région (305) du deuxième type de conductivité formée dans le premier caisson (301) étant connectée à la première borne de connexion (101) du dispositif.

11. Dispositif (200 ; 300) selon l'une quelconque des revendications 7 à 10, comportant en outre, dans une partie du dispositif ne comportant pas la région enterrée (105), un quatrième mur d'isolation vertical (125) délimitant latéralement une deuxième diode (D2) définie par la jonction entre le substrat (101) et la couche semiconductrice (103).

12. Dispositif (200 ; 300) selon la revendication 11, dans lequel la portion de la couche semiconductrice (103) délimitée latéralement par le quatrième mur d'isolation vertical (125) est connectée à la première borne de connexion (101) du dispositif par l'intermédiaire d'une zone de reprise de contact (129).
